# EUROPEAN PATENT APPLICATION

(11) **EP 4 808 305 A1**
(43) Date of publication of application: **16.09.2026**
(21) Application number: 25211802.1
(22) Date of filing: 28.10.2025
(51) Int. Cl.: H10D 12/00, H10D 12/01, H10D 64/00, H10D 62/13, H10D 64/23, H10D 84/00

(54) **IGBT DEVICE AND METHOD FOR MANUFACTURING THE SAME**

(30) Priority: 10.03.2025 CN 202510279453
(71) Applicant: Chongqing Alpha and Omega Semiconductor Limited, Chongqing 400700 (CN)
(72) Inventor: ZHOU, ZHENQIANG, Chongqing, 400700 (CN)
(74) Representative: Metida

(57) **Abstract**

An IGBT device having a power clamping function and a method for manufacturing the same are provided. The IGBT device includes a P region (100), an N-type buffer region (210), an N-drift region (220), a P-type body region (310), N+ regions (330), P+ regions (320), front gate trench structures (500), a collector metal (800) and an emitter metal (600). The collector metal (800) is connected to SBR gate trench structures (700). The SBR gate trench structures (700) are configured to suppress a decrease in a resistance of the N- drift region (220) when an induced voltage on the IGBT device exceeds a predetermined threshold. By providing the SBR gate trench structures (700), when subjected to a large voltage surge, the IGBT device limits a decrease of a resistance of the N- drift region (220), preventing a significant increase in current flowing through the IGBT device.

## Description

### TECHNICAL FIELD

The present disclosure relates to a technical field of power semiconductors, and in particular to an insulated gate bipolar transistor (IGBT) device having a power clamping function and a method for manufacturing the same.

### BACKGROUND

An insulated gate bipolar transistor (IGBT) device is a fully controlled, voltage-driven, composite power semiconductor device composed of a bipolar junction transistor (BJT) and a metal-oxide semiconductor (MOS). The IGBT device combines advantages of a high input impedance of a metal-oxide-semiconductor transistor (MOSFET) and a low on-state voltage drop of a giant transistor (GTR). Under the same voltage, the GTR has a low saturation voltage drop and high current density, but also offers high drive currents. The MOSFET, on the other hand, offers low drive power and fast switching speeds, but has high on-state voltage drop and low current density. The IGBT device combines the advantages of both the GTR and the MOSFET, offering low drive power and low saturation voltage drop. Therefore, the IGBT device is suitable for power conversion systems with direct current (DC) voltages not less than hundreds of volts, such as AC motors, inverters, switching power supplies, lighting circuits, and traction drives.

Due to the high currents applied, use of the IGBT device inevitably involves induced voltage surges caused by inductive loads or parasitic inductance during a switching process. When a conventional IGBT device is frequently turned off at a high current, a ratio of a total collector-emitter voltage to a power bus voltage, and a ratio of a current to a normal shutdown current, often reach significant values, such as 2-3 or even greater. Consequently, the maximum instantaneous power of the conventional IGBT is likely to exceed an actual maximum power rating, causing the conventional IGBT device to fail during the shutdown process.

### SUMMARY

In view of defects in the prior art, the present disclosure provides an insulated gate bipolar transistor (IGBT) device having a power clamping function and a method for manufacturing the same.

In a first aspect, the present disclosure provides an IGBT device having a power clamping function. The IGBT device comprises a P region, an N-type buffer region, and an N- drift region.

The P region, the N-type buffer region, and the N-drift region are sequentially disposed from bottom to top. The P region is P-type doped. The N-type buffer region is N-type doped. The N-drift region is N-type lightly doped. A collector metal is disposed on a lower end of the P region. The collector metal is connected to super barrier rectifier (SBR) gate trench structures. The SBR gate trench structures are configured to suppress a decrease in a resistance of the N- drift region when an induced voltage on the IGBT device exceeds a predetermined threshold.

A P-type body region is disposed on an upper portion of the N-drift region, and the P-type body region is P-type doped. Front gate trench structures are disposed in the P-type body region. The front gate trench structures run through the P-type body region downwards and extend into the N- drift region.

N + regions are disposed on an upper portion of the P-type body region. The N + regions are respectively disposed on two sides of each of the front gate trench structures. The N + regions are N-type heavily doped.

P + regions are disposed on the upper portion of the P-type body region. Each of the P + regions is disposed on one side of a corresponding one of the N + regions away from a corresponding one of the front gate trench structures. The P + regions are P-type heavily doped.

A dielectric layer is disposed on an upper end of the P-type body region. An emitter metal is disposed on the dielectric layer. The emitter metal is connected to the P + regions and the N + regions through contact holes defined in the dielectric layer.

Furthermore, each of the SBR gate trench structures comprises a rear trench, a rear gate oxide layer formed on a trench wall of the rear trench, and a rear gate filled in the rear trench. Each rear trench upwardly runs through the P region from a lower end surface of the P region and extends into the N-type buffer region.

Furthermore, a depth of each rear trench is 0.3-5µm.

Furthermore, a thickness of each rear gate oxide layer is 30-150A.

Furthermore, a doping concentration of the P region is 1E15-1E17 cm⁻³.

Furthermore, each of the front gate trench structures comprises a front trench, a front gate oxide layer formed on a trench wall of the front trench, and a front gate filled in the front trench. Each front trench runs through the P-type body region and extends into the N- drift region.

Furthermore, a center-to-center distance between each two adjacent SBR gate trench structures is 0.5- 10 µm.

In a second aspect, the present disclosure provides a method for manufacturing an IGBT device having a power clamping function. The method comprises steps:
S100: taking a wafer having a front surface and a rear surface opposite to the front surface, enabling the front surface of the wafer to face upward, and forming front gate trench structures, a dielectric layer and contact holes on the front surface of the wafer, and thinning the rear surface of the wafer;
S200: vertically flipping the wafer, and injecting P-type impurities on the rear surface of the wafer and activating the P-type impurities to form a P region;
S300: photoetching rear trenches on the rear surface of the wafer, where the rear trenches run through the P region and extend into an N-type buffer region;
S400: forming a rear gate oxide layer on a trench wall of each of the rear trenches;
S500: depositing first polysilicon in each of the rear trenches and etching back to form a rear gate in each of the rear trenches;
S600: depositing a rear metal on the rear surface of the wafer, and performing heat treatment to form a collector metal; and
S700: vertically flipping the wafer again and processing the wafer to obtain IGBT device.

Furthermore, forming the front gate trench structures, the dielectric layer and the contact holes on the front surface of the wafer comprises steps:
S110: forming the N-type buffer region and an N- drift region;
S120: forming the front trenches in the N- drift region;
S130: forming a front gate oxide layer on a trench wall of each of the front trenches;
S140: depositing second polysilicon in each of the front trenches the and etching to form a front gate in each of the front trenches;
S150: performing ion implantation on an upper portion of the N- drift region to form a P-type body region, N + regions, and P + regions;
S160: growing the dielectric layer on the front surface of the wafer; and
S 170: forming the contact holes corresponding to the N + regions and the P + regions on the dielectric layer.

Furthermore, a depth of each of the rear trenches is 0.3-5µm.

In the present disclosure, by providing the SBR gate trench structures connected to the collector metal (i.e., a collector electrode) to the IGBT device and adjusting a doping concentration of the P region, a hole injection amount is appropriately adjusted, thereby limiting conductivity modulation and achieving power clamping. When subjected to a large voltage surge, the IGBT device limits a decrease of a resistance of the N- drift region, preventing a significant increase in current flowing through the IGBT device. The IGBT device significantly reduces a maximum instantaneous power of the induced voltage, thereby triggering power clamping and extending the service life of the IGBT device under harsh operating conditions.

### BRIEF DESCRIPTION OF DRAWINGS

FIG. 1 is a schematic diagram of an IGBT device having a power clamping function according to one embodiment of the present disclosure.
FIG. 2 is a flow chart of a method for manufacturing the IGBT device according to one embodiment of the present disclosure.
FIG. 3 is a schematic diagram of a structure obtained after forming front gate trench structures, a dielectric layer, and contact holes on a wafer.
FIG. 4 is a schematic diagram of a structure obtained after forming a P region on the wafer.
FIG. 5 is a schematic diagram of a structure obtained after forming rear trenches on the wafer.
FIG. 6 is a schematic diagram of a structure obtained after forming SBR gate trench structures on the wafer.
FIG. 7 is a schematic diagram of a structure obtained after forming a collector metal.

### DETAILED DESCRIPTION

When a conventional insulated gate bipolar transistor (IGBT) device is frequently turned off at high current, an instantaneous peak of an induced voltage generated may exceed a power bus voltage, and a total voltage between a collector and an emitter thereof may exceed twice the power bus voltage. Since a voltage drop of a PN junction between the collector and an N- drift region also increases, an amount of holes injected from the collector into the N- drift region of the conventional IGBT device also increases proportionally, risking a sudden drop in a resistance of the N-drift region, which significantly reduces an on-resistance of the conventional IGBT device. Consequently, when the conventional IGBT device is frequently turned off at high current, the total voltage and the current between the collector and emitter increase simultaneously, resulting in a high instantaneous power output. Under extreme conditions, such as a hard turn-off signal from a gate drive and lack of effective power limiting in a specific application circuit, a ratio of the total voltage between the collector and emitter to the power bus voltage, and a ratio of the current to a normal turn-off current, generally reach significant values, such as 2-3, or even greater. Therefore, the maximum instantaneous power may exceed the maximum power actually allowed by the conventional IGBT device, thereby causing the conventional IGBT device to fail during a shutdown process.

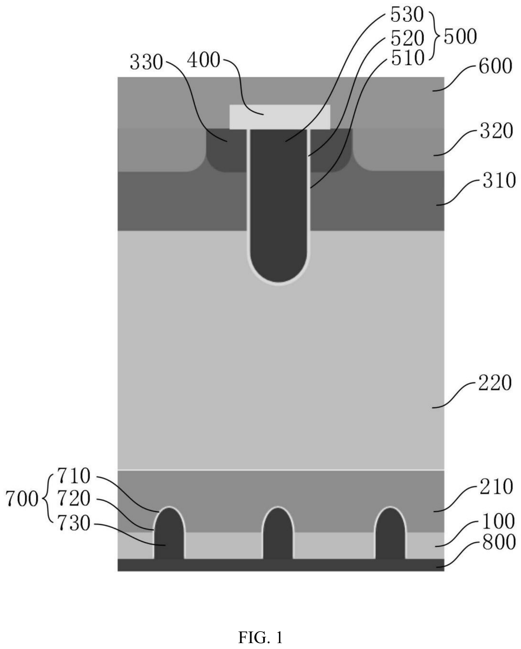

FIG. 1 is a schematic diagram of an IGBT device having a power clamping function according to one embodiment of the present disclosure. As shown in FIG. 1, the IGBT device comprises a P region 100, an N-type buffer region 210, and an N- drift region 220. The P region 100, the N-type buffer region 210, and the N-drift region are sequentially disposed from bottom to top. The P region 100 is P-type doped. The N-type buffer region 210 is N-type doped. The N-drift region is N-type lightly doped. A thickness of the N-type buffer region 210 is generally 5-25 µm. A thickness of the N- drift region 220 is highly correlated with a withstand voltage of the IGBT device, and is generally 650V/50 µm.

A collector metal 800 is disposed on a lower end of the P region 100. The collector metal 800 is connected to super barrier rectifier (SBR) gate trench structures. The SBR gate trench structures 700 are configured to suppress a decrease in a resistance of the N- drift region 220 when an induced voltage on the IGBT device exceeds a predetermined threshold.

A P-type body region 310 is disposed on an upper portion of the N-drift region, and the P-type body region 310 is P-type doped. Front gate trench structures 500 are disposed in the P-type body region 310. The front gate trench structures 500 run through the P-type body region 310 downwards and extends into the N- drift region 220. In the embodiment, each of the front gate trench structures 500 comprises a front trench 510, a front gate oxide layer 520 formed on a trench wall of the front trench 510, and a front gate 530 filled in the front trench 510. Each front trench 510 runs through the P-type body region 310 and extends into the N- drift region 220.

N + regions 330 are disposed on an upper portion of the P-type body region 310. The N + regions 330 are respectively disposed on two sides of each of the front gate trench structures 500. The N + regions 330 are N-type heavily doped.

P + regions 320 are disposed on the upper portion of the P-type body region 310. Each of the P + regions 320 is disposed on one side of a corresponding one of the N + regions 330 away from a corresponding one of the front gate trench structures 500. The P + regions 320 are P-type heavily doped. A dielectric layer 400 is disposed on an upper end of the P-type body region 310. An emitter metal 600 is disposed on the dielectric layer 400. The emitter metal 600 is connected to the P + regions 320 and the N + regions 330 through contact holes 410 defined in the dielectric layer 400.

In the embodiment, each of the SBR gate trench structures 700 comprises a rear trench 710, a rear gate oxide layer 720 formed on a trench wall of the rear trench, and a rear gate 730 filled in the rear trench 710. Each rear trench upwardly runs through the P region 100 from a lower end surface of the P region 100 and extends into the N-type buffer region 210. By configuring the SBR gate trench structures 700 on a rear side of the IGBT device, an SBR structure is formed.

A turn-on voltage of the SBR structure is adjusted by a depth of each of the SBR gate trench structures 700, a thickness of each rear gate oxide layer 720, and a doping concentration of the P region 100. The shallower the depth of each of the SBR gate trench structures 700, the thinner each rear gate oxide layer 720, or the lower the doping concentration of the P region 100, the lower the turn-on voltage of the SBR structure. The P region 100 is generally equipped with the SBR gate trench structures 700. A degree to which the SBR structure suppresses the decrease in resistance of the N- drift region is adjusted by a turn-on voltage of each of the SBR gate trench structures 700 and a pitch of the SBR gate trench structures 700 (i.e., a center-to-center distance between each two adjacent SBR gate trench structures 700). The lower the turn-on voltage of each of the SBR gate trench structures 700 or the smaller the pitch of the SBR gate trench structures 700, the greater the ability of each of the SBR gate trench structures 700 to suppress a decrease in a resistance of the N- drift region, and the more pronounced the power clamping effect. Therefore, structural parameters of the IGBT device of the embodiment are able to be optimized according to specific application requirements to achieve better application performance. After the pitch of the SBR gate trench structures 700 is determined, the number of the SBR gate trench structures 700 is determined.

Furthermore, a depth of each rear trench (i.e., the depth of each of the SBR gate trench structures 700) is 0.3-5µm. The thickness of the P region 100 is less than the depth of each rear trench 710. The thickness of each rear gate oxide layer is 30-150A. A doping concentration of the P region 100 is 1E15-1E17 cm^{-3.} The center-to-center distance between each two adjacent SBR gate trench structures 700 is 0.5-10 µm.

In the embodiment, when the induced voltage on the IGBT device is small and insufficient to trigger the SBR structure to turn on, the IGBT device operates in the same mode as the conventional IGBT device. That is, the IGBT device operates in the same manner as the conventional IGBT device, and the SBR gate trench structure s700 is inoperative.

When the induced voltage on the IGBT device is large, a voltage drop between the collector metal 800 and the N-type buffer region 210 (or the N- drift region 220) increases. When the voltage drop reaches the turn-on voltage of the SBR structure formed by the SBR gate trench structures 700, an N-type conductive channel is formed between the collector metal 800 and the N-type buffer region 210 (or the N- drift region 220), thereby reducing the voltage drop across the PN junction between the collector metal and the N-type buffer region 210 (or the N- drift region 220). Therefore, an amount of holes injected from the collector metal into the N- drift region 220 is limited, while a resistance of the N-drift region 220 is prevented from further decreasing, thereby preventing an increase in current. Compared with the conventional IGBT devices, the IGBT device of the embodiment achieves an effect of triggering power clamping.

When the voltage drop between the collector metal and the N-buffer region 210 (or the N- drift region 220) drops below the turn-on voltage of the SBR structure, the SBR structure immediately shuts down, and the IGBT device resets to operate in the same manner as the conventional IGBT device.

During a working process, the IGBT device is inevitably subject to induced voltage surges (i.e., the induced voltage on the IGBT device exceeds a predetermined threshold). When subjected to a large induced voltage surge, the IGBT device of the embodiment promptly turns on the SBR structure integrated on the collector metal, limiting the amount of holes injected from the collector metal into the N- drift region 220. In this way, the decrease in resistance of the N- drift region is limited, thereby preventing a significant increase in current flowing through it. The IGBT device significantly reduces the maximum instantaneous power of the induced voltage, thereby achieving the effect of triggering power clamping. Therefore, a safe operating region of the IGBT device is broadened and the service life of the IGBT device increases under harsh operating conditions. In terms of specific parameter indicators, compared with the IGBT device of the same specifications, a structure of the IGBT device enables the collector metal and emitter metal thereof to withstand a larger dV/dt (voltage change rate). Moreover, in fixed voltage applications or test environments, the IGBT device appropriately reduces short-circuit current, thereby increasing the short-circuit time it can withstand.

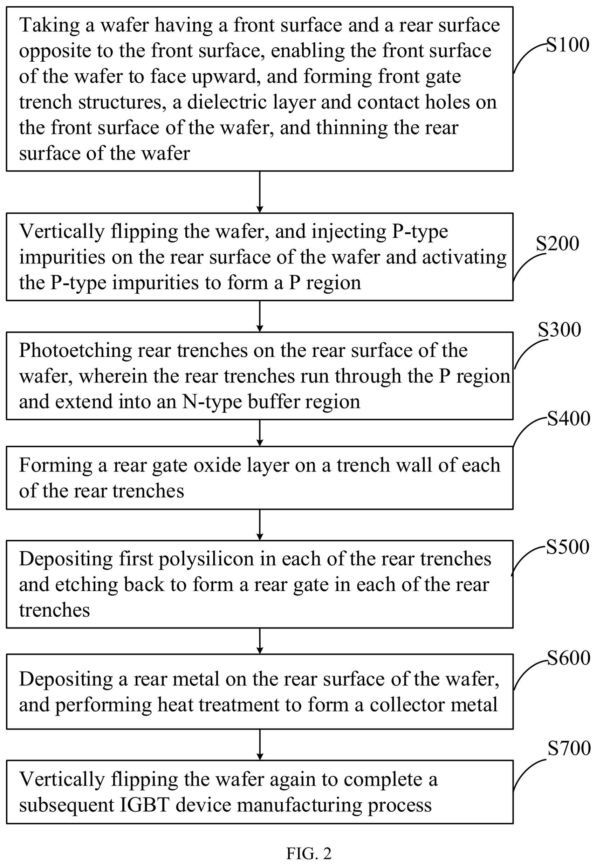

FIG. 2 is a flow chart of a method for manufacturing the IGBT device according to one embodiment of the present disclosure. As shown in FIG. 2, the method comprises steps S100-S700.

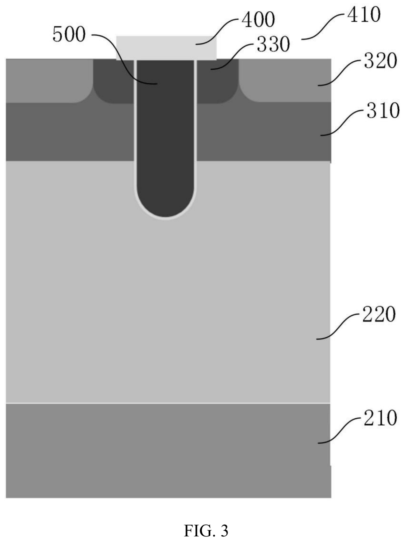

As shown in FIG. 3, the step S100 comprises taking a wafer having a front surface and a rear surface opposite to the front surface, enabling the front surface of the wafer to face upward, and forming front gate trench structures, a dielectric layer 400 and contact holes 410 on the front surface of the wafer, and thinning the rear surface of the wafer.

Furthermore, forming the front gate trench structures, the dielectric layer 400 and the contact holes 410 on the front surface of the wafer comprises steps A110-S170.

The step S110 comprises forming the N-type buffer region 210 and an N- drift region 220 on the wafer. A thickness of the N-type buffer region 210 is generally 5-25 µm. A thickness of the N- drift region 220 is highly correlated with a withstand voltage of the IGBT device, and is generally 650V/50 µm.

The step S120 comprises forming the front trenches 510 in the N- drift region 220. Next, front gate trench structures are prepared.

The step S130 comprises forming a front gate oxide layer 520 on a trench wall of each of the front trenches 510 by thermal oxidation. Of course, a first oxide layer is formed on a surface of the N- drift region 220 at this time, and the first oxide layer is removed in subsequent processes.

The step S140 comprises depositing second polysilicon in each of the front trenches and etching to form a front gate 530 in each of the front trenches 510. In this way, the front gate trench structures 500 are formed.

The step S150 comprises performing ion implantation on an upper portion of the N- drift region 220 to form a P-type body region 310, N + regions 330, and P + regions 320.

A lower end of the P-type body region 310 is lower than a lower end of each of the front trenches 510. The N+ regions 330 and the P+ regions 320 are located on an upper portion of the P-type body region 310. Lower ends of the N+ regions 330 and lower ends of the P+ regions 320 are flush and are higher than the lower end of each of the front trenches 510.

The step S160 comprises growing the dielectric layer 400 on the front surface of the wafer.

The step S170 comprises forming the contact holes 410 corresponding to the N + regions 330 and the P + regions 320 on the dielectric layer 400.

It should be noted that, since FIG. 3 and subsequent figures only illustrate one cell region structure, only a portion of the contact holes 410 is shown in the figures, and the contact holes 410 are not completely shown.

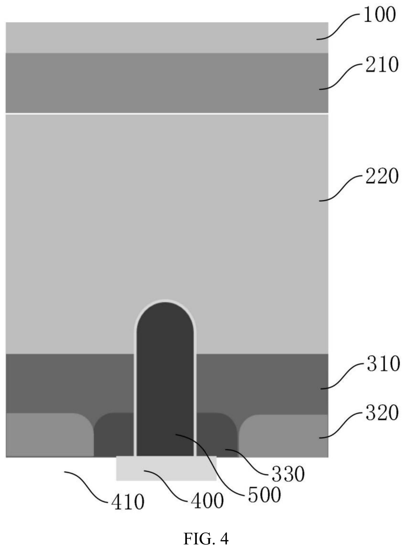

As shown in FIG. 4, the step S200 comprises vertically flipping the wafer, and injecting P-type impurities on the rear surface of the wafer and activating the P-type impurities to form a P region 100. A doping concentration of the P region 100 is determined according to the turn-on voltage of the SBR structure and is 1E15-1E17 cm⁻³.A thickness of the P region 100 needs to be less than a thickness of each of the rear trenches 710 to be manufactured subsequently.

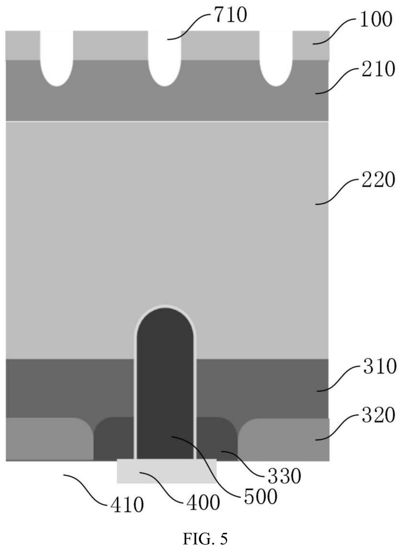

As shown in FIG. 5, the step S300 comprises photoetching rear trenches on the rear surface of the wafer where the SBR gate trench structures 700 are to be formed by photolithography. The rear trenches run through the P region 100 and extend into an N-type buffer region 210. The rear trenches 710 are generally defined in each cell region structure. A depth of each of the rear trenches 710 (i.e., the depth of each of the SBR gate trench structures 700) is determined based on the turn-on voltage of the SBR structure. The depth of each of the rear trenches 710 is 0.3-5 µm. The center-to-center distance between each adjacent rear trenches 710 (i.e., the pitch of the subsequently formed SBR gate trench structures 700) is determined based on a degree to which the SBR structure suppresses the decrease of the resistance of the N- drift region.

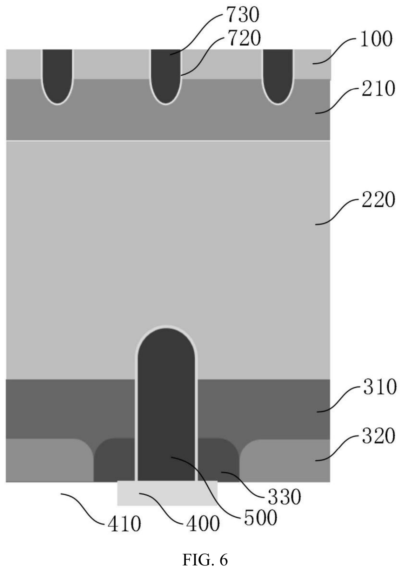

As shown in FIG. 6, the step S400 comprises forming a rear gate oxide layer 720 on a trench wall of each of the rear trenches 710 by thermal oxidation. A thickness of each rear gate oxide layer is 30-150A. Of course, a second oxide layer is formed on the surface of the P region 100 at this time, and the second oxide layer is removed in subsequent processes.

As shown in FIG. 6, the step S500 comprises depositing first polysilicon in each of the rear trenches and etching back to form a rear gate in each of the rear trenches. Then, the oxide layers are wet-etched (an etching thickness of which is slightly greater than each rear gate oxide layer 720 in each of the rear trenches 710), and then a rapid annealing process is performed to form the SBR gate trench structures 700.

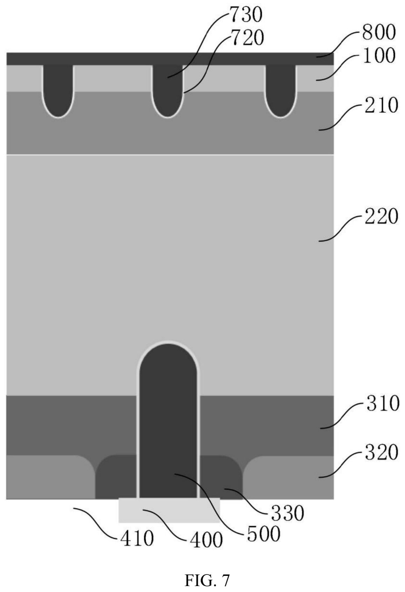

As shown in FIG. 7, the step S600 comprises depositing a rear metal on the rear surface of the wafer, and performing heat treatment to form a collector metal 800.

As shown in FIG. 1, the step S700 comprises vertically flipping the wafer again to complete a subsequent IGBT device manufacturing process.

The step S700 specifically comprises step S710-S730.

The step S710 comprises depositing a front metal, and forming an emitter metal 600 by etching.

The step S720 comprises depositing a passivation layer and etching, and depositing polyimide and etching. By depositing the passivation layer and etching, and by depositing the polyimide and etching, a pad region is exposed, and the passivation layer and the polyimide coverage are maintained in a non-pad region. The pad region is a package bonding or patch region reserved on a chip for packaging leads and heat transfer. These structures are manufactured as in the prior art, so the above structures are not shown in the figures.

The step S730 comprises after performing preetching of the polyimide and the passivation layer on the rear surface of the wafer, obtaining a single IGBT device by dicing and packaging.

In the present disclosure, when subjected to a large voltage surge, the IGBT device limits the decrease of the resistance of the N- drift region 220, preventing a significant increase in current flowing through the IGBT device. The IGBT device significantly reduces the maximum instantaneous power of the induced voltage, thereby triggering power clamping. The structure of the IGBT device enables the collector metal and emitter metal thereof to withstand the larger dV/dt. Moreover, in fixed voltage applications or test environments, the IGBT device appropriately reduces short-circuit current, thereby increasing the short-circuit time it can withstand and extending the service life of the IGBT device under harsh operating conditions.

## Claims

1. An insulated gate bipolar transistor (IGBT) device having a power clamping function, comprising:
a P region (100);
an N-type buffer region (210); and
an N- drift region (220);
wherein the P region (100), the N-type buffer region (210), and the N-drift region are sequentially disposed from bottom to top;
wherein the P region (100) is P-type doped, the N-type buffer region (210) is N-type doped, and the N-drift region is N-type lightly doped, a collector metal (800) is disposed on a lower end of the P region (100), and the collector metal (800) is connected to super barrier rectifier (SBR) gate trench structures;
wherein the SBR gate trench structures (700) are configured to suppress a decrease in a resistance of the N- drift region (220) when an induced voltage on the IGBT device exceeds a predetermined threshold;
wherein a P-type body region (310) is disposed on an upper portion of the N-drift region, and the P-type body region (310) is P-type doped, front gate trench structures (500) are disposed in the P-type body region (310), and the front gate trench structures (500) run through the P-type body region (310) downwards and extend into the N- drift region (220);
wherein N + regions (330) are disposed on an upper portion of the P-type body region (310), the N + regions (330) are respectively disposed on two sides of each of the front gate trench structures (500), and the N + regions (330) are N-type heavily doped;
wherein P + regions (320) are disposed on the upper portion of the P-type body region (310), each of the P + regions (320) is disposed on one side of a corresponding one of the N + regions (330) away from a corresponding one of the front gate trench structures (500), and the P + regions (320) are P-type heavily doped;
wherein a dielectric layer (400) is disposed on an upper end of the P-type body region (310), an emitter metal (600) is disposed on the dielectric layer (400), and the emitter metal (600) is connected to the P + regions (320) and the N + regions (330) through contact holes (410) defined in the dielectric layer (400).

2. The IGBT device of claim 1, wherein each of the SBR gate trench structures (700) comprises a rear trench (710), a rear gate oxide layer (720) formed on a trench wall of the rear trench (710), and a rear gate (730) filled in the rear trench (710);
wherein each rear trench (710) upwardly runs through the P region (100) from a lower end surface of the P region (100) and extends into the N-type buffer region (210).

3. The IGBT device of claim 2, wherein a depth of each rear trench (710) is 0.3-5µm.

4. The IGBT device of claim 2, wherein a thickness of each rear gate oxide layer (720) is 30-150A.

5. The IGBT device of claim 2, wherein a doping concentration of the P region (100) is 1E15-1E17 cm⁻³.

6. The IGBT device of any one of claims 1-5, wherein each of the front gate trench structures (500) comprises a front trench (510), a front gate oxide layer (520) formed on a trench wall of the front trench (510), and a front gate (530) filled in the front trench (510);
wherein each front trench (510) runs through the P-type body region (310) and extends into the N- drift region (220).

7. The IGBT device of any one of claims 1-5, wherein a center-to-center distance between each two adjacent SBR gate trench structures (700) is 0.5- 10 µm.

8. A method for manufacturing an IGBT device having a power clamping function, comprising steps:
S100: taking a wafer having a front surface and a rear surface opposite to the front surface, enabling the front surface of the wafer to face upward, and forming front gate trench structures (500), a dielectric layer (400) and contact holes (410) on the front surface of the wafer, and thinning the rear surface of the wafer;
S200: vertically flipping the wafer, and injecting P-type impurities on the rear surface of the wafer and activating the P-type impurities to form a P region (100);
S300: photoetching rear trenches (710) on the rear surface of the wafer, wherein the rear trenches (710) run through the P region (100) and extend into an N-type buffer region (210);
S400: forming a rear gate oxide layer (720) on a trench wall of each of the rear trenches (710);
S500: depositing first polysilicon in each of the rear trenches (710) and etching back to form a rear gate (730) in each of the rear trenches (710);
S600: depositing a rear metal on the rear surface of the wafer, and performing heat treatment to form a collector metal (800); and
S700: vertically flipping the wafer again to complete a subsequent IGBT device manufacturing process.

9. The method of claim 8, wherein forming the front gate trench structures (500), the dielectric layer (400) and the contact holes (410) on the front surface of the wafer comprises steps:
S110: forming the N-type buffer region (210) and an N- drift region (220);
S120: forming the front trenches (510) in the N- drift region (220);
S130: forming a front gate oxide layer (520) on a trench wall of each of the front trenches (510);
S140: depositing second polysilicon in each of the front trenches (510) and etching to form a front gate (530) in each of the front trenches (510);
S150: performing ion implantation on an upper portion of the N- drift region (220) to form a P-type body region (310), N + regions (330), and P + regions (320);
S160: growing the dielectric layer (400) on the front surface of the wafer;
S170: forming the contact holes (410) corresponding to the N + regions (330) and the P + regions (320) on the dielectric layer (400).

10. The method of claim 8, wherein a depth of each of the rear trenches (710) is 0.3-5µm.
